# EUROPEAN PATENT SPECIFICATION

(11) **EP 0 524 714 B1**
(45) Date of publication and mention of the grant of the patent: **21.05.1997**
(21) Application number: 92302227.1
(22) Date of filing: 16.03.1992
(51) Int. Cl.: H01L 27/148, H01L 31/0232

(54) **A solid-state camera device**
Festkörperkamera
Caméra à l'état solide

(30) Priority: 15.07.1991 JP 174168/91
(43) Date of publication of application: 27.01.1993
(73) Proprietor: SHARP KABUSHIKI KAISHA, Osaka 545 (JP)
(72) Inventor: Nakai, Junichi, Fukuyama-shi, Hiroshima-ken (JP); Naka, Shunichi, Habikino-shi, Osaka (JP)
(74) Representative: Brown, Kenneth Richard

(56) References cited:
- EP-A- 0 354 280
- EP-A- 0 488 131
- US-A- 4 667 092
- PATENT ABSTRACTS OF JAPAN vol. 14, no. 371 (E-963)10 August 1990 & JP-A-21 34 993
- PATENT ABSTRACTS OF JAPAN vol. 11, no. 338 (E-553)5 November 1987 & JP-A-62 119 965
- INTERNATIONAL ELECTRON DEVICES MEETING 5 December 1983, WASHINGTON,DC,US pages 497 - 500 Y.ISHIHARA ET AL. 'A HIGH PHOTOSENSITIVITY IL-CCD IMAGE SENSOR WITH MONOLITHIC RESIN LENS ARRAY'
- PATENT ABSTRACTS OF JAPAN vol. 13, no. 26 (E-706)20 January 1989 & JP-A-63 229 851
- PATENT ABSTRACTS OF JAPAN vol. 15, no. 383 (E-1116)27 September 1991 & JP-A-03 152 973
- PATENT ABSTRACTS OF JAPAN vol. 16, no. 166 (E-1193)22 April 1992 & JP-04 014 257
- PATENT ABSTRACTS OF JAPAN vol. 16, no. 97 (E-1176)10 March 1992 & JP-A-03 276 678

## Description

### BACKGROUND OF THE INVENTION

### 1. Field of the Invention :

The present invention relates to a solid-state image sensor device comprising a CCD (charge coupled device) and the like, which is used for an area sensor, a line sensor, etc.

### 2. Description of the Prior Art:

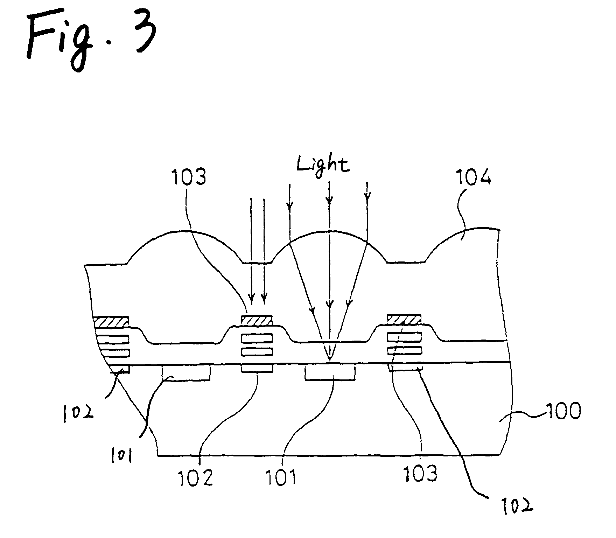

Figure **3** shows a conventional solid-state camera device. This device comprises, on a substrate **100**, a plurality of photoreceiving portions **101** such as photo diodes, transfer portions **102** disposed between the photoreceiving portions **101**, and photointercepting metal portions **103** above the transfer portions **102**. The photoreceiving portions **101** convert incident light into electrical signals, and the transfer portions **102** successively transfer the electrical signals from the photoreceiving portions **101** to an output (not shown).

In the case of the above-mentioned conventional device, an aluminium wiring is used for the photointercepting metal portion as in an LSI, an IC, and the like. As this aluminium wiring, aluminium with a high purity, aluminium to which several percent of silicon is added, or aluminium to which silicon and copper are added is used.

However, there are the following problems. The above-mentioned aluminium wiring has a reflection coefficient of 80 to 100% with respect to incident light, so that an irregular reflection is likely to be caused. Because of this, when a part of the reflected light is incident upon the photoreceiving portions **101**, noise signals caused by the incidence of the reflected light and image signals are overlapped, resulting in an image irregularity. Moreover, the difference is caused among electrical signals from the photoreceiving portions disposed in parallel with the transfer portions **102** sandwiched therebetween, generating brightness irregularity.

In order to overcome the above-mentioned problems, it has been proposed that aluminium to which W (tungsten) is added in an amount of several ppm to hundreds of ppm so as to control the reflection coefficient is used, or the aluminium wiring is covered with a film made from TiW or TiN having a thickness of hundreds of angstroms. However, according to these methods, a quite expensive sputtering device or vapour deposition device which costs about several hundred million yen is required for forming the photointercepting metal portions or covering films disposed thereon, leading to a cost burden problem.

JP-A-2-134 993 and JP-A-62-119965 each disclose a solid-state image pickup element in which a light-shielding aluminium film is covered on its upper surface only by a reflection preventing film.

### SUMMARY OF THE INVENTION

In one aspect the present invention provides the solid-state image sensor device defined by claim 1.

In another aspect the present invention provides methods defined by claims 5 and 7 for producing a solid-state image sensor device.

The sub-claims are directed to embodiments of the invention.

According to the present invention, the photoabsorbing films, formed on both the upper and the side surfaces of the photointercepting metal portions, are present in the optical paths of light incident upon the photointercepting metal portions. As a result, irregular light reflected from the photointercepting metal portions can be absorbed by these films. Thus, excessive light reflected from the photointercepting metal portions can be prevented from being incident upon the photoreceiving portions. In addition, the photoabsorbing films are formed by photoetching, so that an expensive sputtering device or vapour deposition device is not required.

Thus, the present invention makes possible the objective of providing a solid-state image sensor device in which brightness irregularity and image irregularity can be eliminated by preventing irregular light from being incident upon the photoreceiving portions from the photointercepting metal portions without using an expensive manufacturing device.

### BRIEF DESCRIPTION OF THE DRAWINGS

Figure **1** is a sectional view showing a solid-state camera device according to an embodiment of the present invention.

Figure **2** is a top view showing the solid-state camera device.

Figure **3** is a sectional view showing a conventional solid-state camera device.

### DESCRIPTION OF THE PREFERRED EMBODIMENT

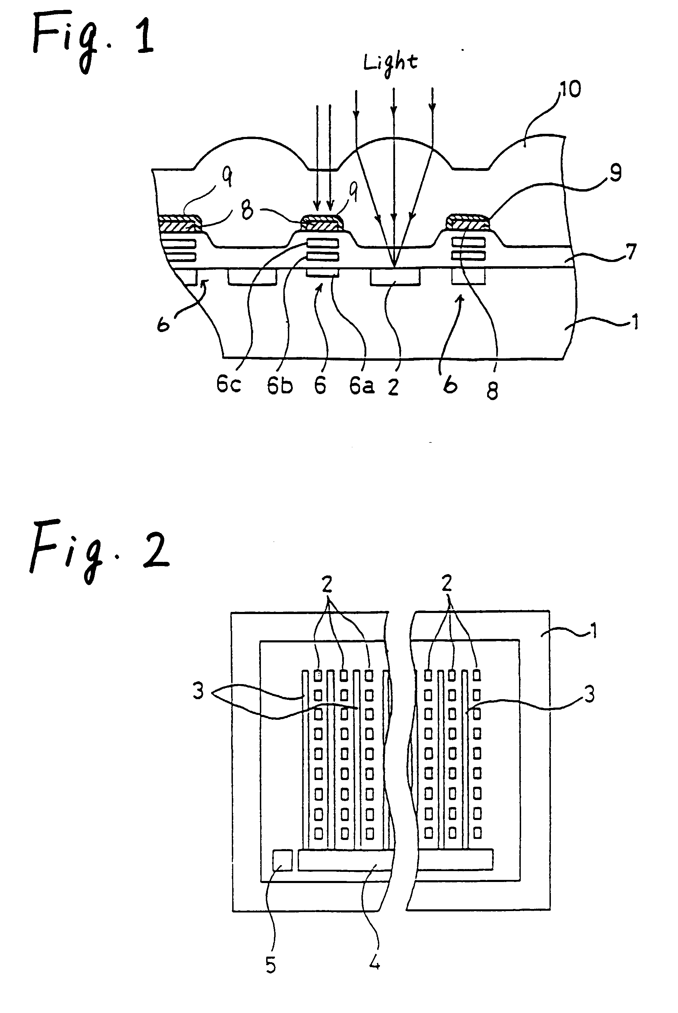

A CCD solid-state camera device of an interline transfer structure according to the present invention is shown in Figures **1** and **2**. As shown in Figure **2**, this device comprises a plurality of photoreceiving portions **2** in which photodiodes are arranged in a plurality of arrays on a semiconductor substrate **1**, vertical register portions **3** disposed between each array of the photoreceiving portions **2**, horizontal register portions **4** connecting one end of each vertical register portion **3**, and an output **5** provided in the vicinity of the horizontal register portion **4**.

As shown in Figure **1**, transfer portions **6** are formed in the vicinity of each photoreceiving portion **2**. The transfer portions **6** comprise n⁺ layers **6a** formed on the upper portion of the semiconductor substrate **1**, and two polysilicon electrodes **6b** and **6c** which face each other, corresponding to the vertical register portions **3**. These two polysilicon electrodes **6b** and **6c** are included in a silicon oxide insulation film **7**. The transfer portions **6** thus constructed transfer electrical signals from the photoreceiving portions **2** having a photoelectric transfer function in accordance with an amount of incident light, and photointercepting metal portions **8** are formed on the silicon oxide insulation film **7** above the transfer portions **6**. As the photointercepting metal portion **8**, an aluminium wiring made of aluminium with a high purity is used. Instead of this kind of aluminium wiring, an aluminium wiring made of aluminium to which several percent of silicon is added or aluminium to which silicon and copper are added can be used.

Photoabsorbing films **9** cover the photointercepting metal portions **8**, excluding the lower surface which is in contact with the silicon oxide insulation film **7**. The photoabsorbing films **9** are formed by attaching a resin, to which there has been added dyes or pigments capable of absorbing visible radiations, to the surface of the silicon oxide insulation film **7** and photoetching the resin so that portions corresponding to the photo intercepting metal portions **8** remain. As the dyes, Supraud Fast Yellow 4B, Kayanol Yellow N5G, Lissamire Green V, and Ponceau S are used. As the pigments, carbon black, chromium oxide (Cr₂O₃), and titanium oxide (TiO) are used. As the resin, acrylic resin, polyimide resin, and epoxy resin are used. In addition, the photoabsorbing films **9** can be formed by attaching a dyeable material such as casein and gelatin to the surface of the silicon oxide insulation film **7**, photoetching the dyeable material so that portions corresponding to the photointercepting metals **8** remain and dyeing the dyeable material with the above-mentioned dyes capable of absorbing visible radiations. Moreover, the photoabsorbing films **9** can be formed by another method as long as the photoabsorbing films **9** are formed by photoetching so as to cover the upper and side surfaces of the photointercepting metal portions **8**.

Microlenses **10** made of, for example, a transparent resin are formed above the silicon oxide insulation film **7** having the photo intercepting metal portions **8** covered with the photoabsorbing films **9** so as to allow light to be concentratively incident upon the photoreceiving portions **2**. The photointercepting metal portions **8** and photoabsorbing films **9** provided above the transfer portions **6** are disposed in a position excluding optical paths of light transmitted through the microlenses **10**, thereby preventing the amount of light incident upon the photoreceiving portions **2** from decreasing.

Next, the operation of the solid-state camera device thus constructed will be described.

When light is incident upon the photoreceiving portions **2** through the microlenses **10**, the photoreceiving portions **2** convert light into electrical signals in accordance with the amount of incident light. After this, electrical charges are transferred through the vertical CCD register portions **3** by a transfer clock pulse in the direction of the horizontal CCD register portions **4**, and the electrical charges transferred to the horizontal CCD register portions **4** are read out of the output **5** as voltage signals. At this time, since the photointercepting metal portions **8** are covered with the photoabsorbing films **9**, light which is to be irregularly reflected when being incident upon the photo intercepting metal portions **8** is absorbed by the photoabsorbing films **9**. Thus, light is not irregularly reflected from the photointercepting metal portions **8**, eliminating the irregular light incident upon the photoreceiving portions **2**.

According to the solid-state camera device of the present invention, since the irregular light from the photointercepting metal portions **8** is prevented from being incident upon the photoreceiving portions **2**, image signals detected by the photoreceiving portions **2** and image signals transferred from the photoreceiving portions **2** are not adversely affected, whereby image irregularity or brightness irregularity can be prevented. Moreover, since a conventional material can be used for the photointercepting metal portions **8**, and the photoabsorbing films **9** can be formed by photoetching, a solid-state camera device can be provided at a low cost without using the above-mentioned expensive sputtering device or vapour deposition device.

In the embodiment, the present invention is applied to a CCD solid-state camera device of an interline transfer structure. The present invention is not limited thereto and can be applied to a solid-state camera device of a frame transfer structure. Moreover, the present invention can be applied to a solid-state camera device which does not comprise microlenses.

The present invention may be embodied in other specific forms and manners without departure from its scope as defined by the claims.

## Claims

1. A solid-state image sensor device comprising, on a substrate (1), photoreceiving portions (2) having a photoelectric transfer function, transfer portions (6) for transferring electrical signals from the photoreceiving portions, and photointercepting metal portions (8) having upper surfaces and side surfaces and formed above the transfer portions for preventing light from being incident upon the transfer portions, wherein photoabsorbing films (9) are formed only on the photointercepting metal portions (8) so as to cover said upper surfaces and said side surfaces thereof, the photoabsorbing films (9) being made from one of a resin and a dyeable material.

2. A solid-state image sensor device according to claim 1, wherein said resin includes added dyes or pigments which absorb visible radiation.

3. A solid-state image sensor device according to claim 1, wherein said dyeable material is dyed with a dye which absorbs visible radiation.

4. A solid-state image sensor device according to any of claims 1 to 3, wherein microlenses (10) are formed above the respective photoreceiving portions (2).

5. A method for producing a solid-state image sensor device comprising the steps of:
forming a substrate (1),
forming an array of photodetection elements (2) on said substrate (1),
forming transfer elements (6) for receiving electrical signals which, in use, transfer from said photodetection elements,
forming above the transfer elements photointercepting metal portions (8) having upper surfaces and side surfaces for shielding said transfer elements from incident light, and
forming photoabsorbent film elements (9) only on the photointercepting metal portions (8) by photoetching so as to cover said upper surfaces and side surfaces thereof, the photoabsorbent film elements (9) being made from a resin.

6. A method for producing a solid-state image sensor device according to claim 5, wherein said resin includes added dyes or pigments which absorb visible radiation.

7. A method for producing a solid-state image sensor device comprising the steps of:
forming a substrate (1),
forming an array of photodetection elements (2) on said substrate (1),
forming transfer elements (6) for receiving electrical signals which, in use, transfer from said photodetection elements,
forming above the transfer elements photointercepting metal portions (8) having upper surfaces and side surfaces for shielding said transfer elements from incident light, and
forming photoabsorbent film elements (9) only on the photointercepting metal portions (8) by forming a dyeable material layer, photoetching the dyeable material layer so that the remaining portion thereof covers said upper surfaces and side surfaces of the photointercepting metal portions (8), and dyeing said remaining layer portion with a dye which absorbs visible radiation.

8. A method for producing a solid-state image sensor device according to any of claims 5 to 7, further comprising the step of forming microlenses (10) above the respective photodetection elements (2).

## Patentansprüche

1. Festkörper-Bildsensor, der auf einem Substrat (1) folgendes aufweist: Lichtempfangsabschnitte (2), mit photoelektrischer Übertragungsfunktion, Übertragungsabschnitte (6) zum Übertragen elektrischer Signale von den Lichtempfangsabschnitten, und Lichtausblend-Metallabschnitt (8) mit Oberseiten und Seitenflächen, wobei sie über den Übertragungsabschnitten ausgebildet sind, um Licht auszublenden, das auf die Übertragungsabschnitte fällt, wobei Lichtabsorptionsfilme (9) nur auf den Lichtausblend-Metallabschnitten (8) so ausgebildet sind, dass sie die Oberseiten und die Seitenflächen derselben bedecken, wobei diese Lichtabsorptionsfilme (9) aus einem Harz oder einem einfärbbaren Material bestehen.

2. Festkörper-Bildsensor nach Anspruch 2, bei dem das Harz hinzugefügte Farbstoffe oder Pigmente enthält, die sichtbare Strahlung absorbieren.

3. Festkörper-Bildsensor nach Anspruch 1, bei dem das einfärbbare Material durch einen Farbstoff eingefärbt ist, der sichtbare Strahlung absorbiert.

4. Festkörper-Bildsensor nach einem der Ansprüche 1 bis 3, bei dem über den jeweiligen Lichtempfangsabschnitten (2) Mikrolinsen (10) ausgebildet sind.

5. Verfahren zum Herstellen eines Festkörper-Bildsensors, das die folgenden Schritte aufweist:
- Herstellen eines Substrats (1);
- Herstellen einer Anordnung von Lichterfassungselementen (2) auf dem Substrat (1);
- Herstellen von Übertragungselementen (6) zum Empfangen elektrischer Signal ladungen, wie sie in Gebrauch von den Lichtempfangselementen her übertragen werden;
- Herstellen von Lichtausblend-Metallabschnitten (8) mit Oberseiten und Seitenflächen auf den Übertragungselementen, um die Übertragungselemente gegen einfallendes Licht abzuschirmen; und
- Herstellen von Lichtabsorptionsfilm-Elementen (9) nur auf den Lichtausblend-Metallabschnitten (8), und zwar durch Photoätzen in solcher Weise, dass die Oberseiten und die Seitenflächen derselben bedeckt sind, wobei die Lichtabsorptionsfilm-Elemente (9) aus einem Harz bestehen.

6. Verfahren zum Herstellen eines Festkörper-Bildsensors nach Anspruch 5, bei dem das Harz hinzugefügte Farbstoffe oder Pigmente enthält, die sichtbare Strahlung absorbieren.

7. Verfahren zum Herstellen eines Festkörper-Bildsensors, das die folgenden Schritte aufweist:
- Herstellen eines Substrats (1);
- Herstellen einer Anordnung von Lichterfassungselementen (2) auf dem Substrat (1);
- Herstellen von Übertragungselementen (6) zum Empfangen elektrischer Signalladungen, wie sie in Gebrauch von den Lichtempfangselementen her übertragen werden;
- Herstellen von Lichtausblend-Metallabschnitten (8) mit Oberseiten und Seitenflächen auf den Übertragungselementen, um die Übertragungselemente gegen einfallendes Licht abzuschirmen; und
- Herstellen von Lichtabsorptionsfilm-Elementen (9) nur auf den Lichtausblend-Metallabschnitten (8) durch Herstellen einer Schicht aus einem einfärbbaren Material, durch Photoätzen der Schicht aus einfärbbarem Material in solcher Weise, dass der verbliebene Teil desselben die Oberseiten und die Seitenflächen der Lichtausblend-Metallabschnitte (8) bedeckt, und Einfärben des verbliebenen Schichtanteils mit einem Farbstoff, der sichtbare Strahlung absorbiert.

8. Verfahren zum Herstellen eines Festkörper-Bildsensors nach einem der Ansprüche 5 bis 7, ferner mit dem Schritt des Herstellens von Mikrolinsen (10) über den jeweiligen Lichterfassungselementen (2).

## Revendications

1. Dispositif de détection d'images à l'état solide comprenant, sur un substrat (1), des parties photoréceptrices (2) possédant une fonction de transfert photoélectrique, des parties de transfert (6) pour transférer des signaux électriques provenant des parties photoréceptrices, et des parties métalliques de photo-interception (8) comportant des surfaces supérieures et des surfaces latérales et formées au-dessus des parties de transfert pour empêcher que la lumière ne rencontre les parties de transfert, dans lequel des films de photoabsorption (9) sont formés uniquement sur les parties métalliques de photointerception (8) de manière à recouvrir lesdites surfaces supérieures et lesdites surfaces latérales de ces parties, les films de photoabsorption (9) étant formés d'une résine ou d'un matériau pouvant être coloré.

2. Dispositif de détection d'images à l'état solide selon la revendication 1, dans lequel ladite résine comprend des colorants ou des pigments ajoutés, qui absorbent le rayonnement visible.

3. Dispositif de détection d'images à l'état solide selon la revendication 1, dans lequel ledit matériau pouvant être coloré est coloré par un colorant qui absorbe le rayonnement visible.

4. Dispositif de détection d'images à l'état solide selon l'une quelconque des revendications 1 à 3, dans lequel des microlentilles (10) sont formées au-dessus des parties photoréceptrices respectives (2).

5. Procédé pour fabriquer un dispositif de détection d'images à l'état solide comprenant les étapes consistant à :
former un substrat (1),
former un réseau d'éléments photodétecteurs (2) sur ledit substrat (1),
former des éléments de transfert (6) pour recevoir des signaux électriques qui, en fonctionnement, sont transférés à partir desdits éléments photodétecteurs,
former, au-dessus des éléments de transfert, des parties métalliques de photo-interception (8) possédant des surfaces supérieures et des surfaces latérales pour protéger lesdits éléments de transfert vis-à-vis d'une lumière incidente, et
former des éléments de film photoabsorbant (9) uniquement sur les parties métalliques de photo-interception par photocorrosion de manière à recouvrir lesdites surfaces supérieures et lesdites surfaces latérales de ces parties, les éléments de film photoabsorbant (9) étant formés d'une résine.

6. Procédé pour fabriquer un dispositif de détection d'images à l'état solide selon la revendication 5, dans lequel ladite résine inclut des colorants ou pigments ajoutés, qui absorbent le rayonnement visible.

7. Procédé pour fabriquer un dispositif de détection d'images à l'état solide comprenant les étapes consistant à :
former un substrat (1),
former un réseau d'éléments photodétecteurs (2) sur ledit substrat (1),
former des éléments de transfert (6) pour recevoir des signaux électriques qui, en fonctionnement, sont transférés à partir desdits éléments photodétecteurs,
former, au-dessus des éléments de transfert, des parties métalliques de photo-interception (8) possédant des surfaces supérieures et des surfaces latérales pour protéger lesdits éléments de transfert vis-à-vis d'une lumière incidente, et
former des éléments de film photoabsorbant (9) uniquement sur les parties métalliques de photo-interception (8) en formant une couche d'un matériau pouvant être coloré, appliquer une photocorrosion à la couche de matériau pouvant être coloré de sorte que sa partie restante recouvre lesdites surfaces supérieures et lesdites surfaces latérales des parties métalliques de photo-interception (8), et colorer ladite partie restante de la couche avec un colorant qui absorbe le rayonnement visible.

8. Procédé pour fabriquer un dispositif de détection d'images à l'état solide selon l'une quelconque des revendications 5 à 7, comprenant en outre l'étape consistant à former des microlentilles (10) au-dessus des éléments de photodétection respectifs (2).
